# EUROPEAN PATENT APPLICATION

(11) **EP 4 541 940 A1**
(43) Date of publication of application: **23.04.2025**
(21) Application number: 24206344.4
(22) Date of filing: 14.10.2024
(51) Int. Cl.: C23F 1/32, C23F 1/34, C23F 1/36, C23F 1/38, C23F 1/40, C23F 1/44, H01L 21/3213

(54) **ETCHING COMPOSITION, METHOD OF ETCHING METAL-CONTAINING FILM BY USING THE SAME, AND METHOD OF MANUFACTURING SEMICONDUCTOR DEVICE BY USING THE SAME**

(30) Priority: 18.10.2023 KR 20230139894
(71) Applicant: Samsung Electronics Co., Ltd, Suwon-si, Gyeonggi-do 16677 (KR)
(72) Inventor: HAM, Cheol, 16678 Suwon-si (KR); KANG, Byungjoon, 16678 Suwon-si (KR); KO, Giho, 18448 Hwaseong-si (KR); KIM, Sungmin, 16678 Suwon-si (KR); PARK, Mihyun, 18448 Hwaseong-si (KR); PARK, Insun, 16678 Suwon-si (KR); BAE, Jinhye, 18448 Hwaseong-si (KR); LEE, Kum Hee, 16678 Suwon-si (KR); CHO, Minhyung, 18448 Hwaseong-si (KR); HWANG, Kyuyoung, 16678 Suwon-si (KR)
(74) Representative: Elkington and Fife LLP

(57) **Abstract**

Provided are an etching composition, a method of etching a metal-containing film by using the same, and a method of manufacturing a semiconductor device by using the same. The etching composition may include an oxidizing agent, a buffer, and a selective etching inhibitor. The selective etching inhibitor may include a first compound represented by Formula 1 and a second compound different from the first compound. The second compound may include a ring. The ring may be a pyrazole group, an imidazole group, a triazole group, or a tetrazole group, or the ring may be a pyrazole group, an imidazole group, or a triazole group, each condensed with a benzene group, a pyridine group, a pyrimidine group, a pyrazine group, a pyridazine group, or any combination thereof.

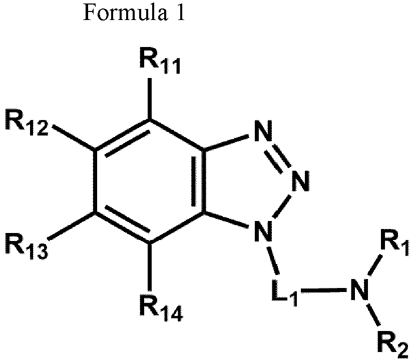

A description of Formula 1 is provided in the present specification.

## Description

### FIELD OF THE INVENTION

The disclosure relates to an etching composition, a method of etching a metal-containing film by using the same, and a method of manufacturing a semiconductor device by using the same.

### BACKGROUND OF THE INVENTION

To satisfy excellent performance and low price demanded by consumers, an increase in the degree of integration and improvement in reliability of semiconductor devices may be required. As the degree of integration of the semiconductor devices increases, damage to components of the semiconductor devices during a process of manufacturing the semiconductor devices may have a greater effect on reliability and electrical characteristics of semiconductor memory devices. In particular, in the process of manufacturing the semiconductor devices, various etching processes may be performed on a desired and/or alternatively predetermined film (e.g., a metal-containing film). However, to perform an effective etching process, the need for an etching composition capable of providing an excellent etching speed, excellent etching selectivity for adjacent films, the absence of surface residues after etching, excellent storage stability, and the like has been continuously demanded.

### SUMMARY OF THE INVENTION

Provided is an etching composition that increases productivity and efficiency of an etching process while having excellent etching selectivity for a metal-containing film that is a target film to be etched.

Additional aspects will be set forth in part in the description which follows and, in part, will be apparent from the description, or may be learned by practice of the presented embodiments of the disclosure.

According to an embodiment of the disclosure, an etching composition may include an oxidizing agent, a buffer, and a selective etching inhibitor. The selective etching inhibitor may include a first compound represented by Formula 1 and a second compound. The first compound and the second compound may be different from each other. The second compound may include a ring. The ring may be one of: a pyrazole group, an imidazole group, a triazole group, or a tetrazole group; or a pyrazole group, an imidazole group, or a triazole group, each condensed with a benzene group, a pyridine group, a pyrimidine group, a pyrazine group, or a pyridazine group, or any combination thereof. 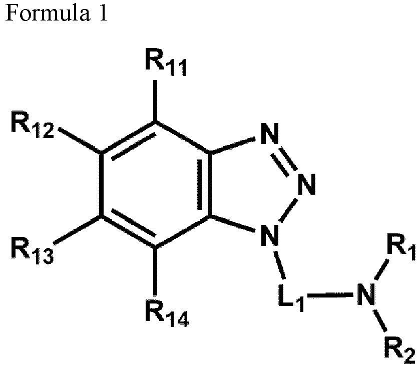 wherein, in Formula 1,
L₁ may be a C₁-C₃₀ alkylene group unsubstituted or substituted with deuterium, *-F, *-Cl, *-Br, *-I, *-OH, or *-SH, or any combination thereof,
R₁ and R₂ may each independently be one of
   hydrogen, deuterium, *-OH, or *-SH, or
   a C₁-C₃₀ alkyl group unsubstituted or substituted with deuterium, *-F, *-Cl, *-Br, *-I, *-OH, *-SH, a C₁-C₃₀ alkoxy group, a C₁-C₃₀ alkylthio group, or any combination thereof,
R₁₁ to R₁₄ may each independently be one of
   hydrogen, deuterium, a cyano group, *-F, *-Cl, *-Br, *-I, *-OH, *-SH, *-C(=O)-Q₁, *-NH-C(=O)-Q₁, *-C(=O)-O-Q₁, *-N(Q₁)(Q₂), or *-(O-CH₂CH₂)ₙ₁-OH, or
   a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, or a C₁-C₃₀ heterocyclic group, each unsubstituted or substituted with deuterium, cyano group, *-F, *-Cl, *-Br, *-I, *-OH, *-SH, *-C(=O)-Q₁₁, *-NH-C(=O)-Q₁₁, *-C(=O)-O-Q₁₁, *-N(Q₁₁)(Q₁₂), *-(O-CH₂CH₂)ₙ₁₁-OH, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof,
n1 and n11 are each independently an integer from 1 to 20,
Q₁, Q₂, Q₁₁, and Q₁₂ may each independently be one of
   hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂, or
   a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof, and
* indicates a binding site to a neighboring atom.

In some embodiments, the oxidizing agent may be hydrogen peroxide.

In some embodiments, the amount of the oxidizing agent may be in a range of 0.1 wt% to 50 wt% based on 100 wt% of the etching composition.

In some embodiments, the buffer may include an ammonium salt.

In some embodiments, the ammonium salt may include a cation represented by Formula 5-1:

Formula 5-1 [N(R₅₁)(R₅₂)(R₅₃)(R₅₄)]⁺

wherein, in Formula 5-1, R₅₁ to R₅₄ may each independently be one of
hydrogen, or
a C₁-C₃₀ alkyl group unsubstituted or substituted with deuterium, *-F, *-Cl, *-Br, *-I, *-OH, *-SH, a C₁-C₃₀ alkoxy group, a C₁-C₃₀ alkylthio group, or any combination thereof.

In some embodiments, the ammonium salt may include a phosphate-containing anion, and the phosphate-containing anion may be dihydrogen phosphate ([H₂PO₄]⁻), hydrogen phosphate ([HPO₄]²⁻), or phosphate ([PO₄]³⁻).

In some embodiments, the amount of the buffer may be in a range of 0.01 wt% to 20 wt% per 100 wt% of the etching composition.

In some embodiments, in Formula 1, at least one of R₁ and R₂ may be a C₁-C₃₀ alkyl group unsubstituted or substituted with *-OH, *-SH, a C₁-C₃₀ alkoxy group, a C₁-C₃₀ alkylthio group, or any combination thereof.

In some embodiments, in Formula 1, at least one of R₁₁ to R₁₄ may not be hydrogen.

In some embodiments, the ring of the second compound may be a pyrazole group, an imidazole group, a triazole group, a tetrazole group, an indazole group, a benzimidazole group, or a benzotriazole group.

In some embodiments, the second compound may include at least one of a compound represented by Formula 2-1 and a compound represented by Formula 2-2: 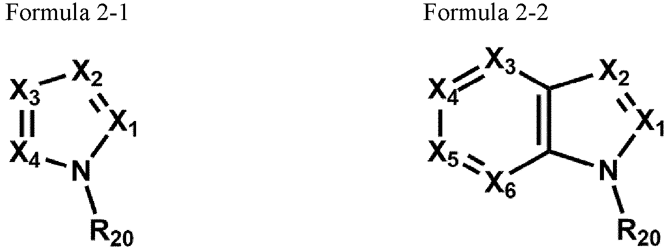 wherein, in Formulae 2-1 and 2-2,
X₁ may be N or C(R₂₁), X₂ may be N or C(R₂₂), X₃ may be N or C(R₂₃), X₄ may be N or C(R₂₄), X₅ may be N or C(R₂₅), and X₆ may be N or C(R₂₆), wherein at least one of X₁ to X₄ in Formula 2-1 may be N, and at least one of X₁ and X₂ in Formula 2-2 may be N,
R₂₀ to R₂₆ may each independently be one of
   hydrogen, deuterium, a cyano group, *-F, *-Cl, *-Br, *-I, *-OH, *-SH, *-C(=O)-Q₁, *-NH-C(=O)-Q₁, *-C(=O)-O-Q₁, *-N(Q₁)(Q₂), or *-(O-CH₂CH₂)ₙ₁-OH, or
   a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, or a C₁-C₃₀ heterocyclic group, each unsubstituted or substituted with deuterium, cyano group, *-F, *-Cl, *-Br, *-I, *-OH, *-SH, *-C(=O)-Q₁₁, *-NH-C(=O)-Q₁₁, *-C(=O)-O-Q₁₁, *-N(Q₁₁)(Q₁₂), *-(O-CH₂CH₂)ₙ₁₁-OH, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof,
n1 and n11 may each independently be an integer from 1 to 20, and
Q₁, Q₂, Q₁₁, and Q₁₂ may each independently be one of
   hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂, or
   a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof.

In some embodiments, in Formulae 2-1 and 2-2, R₂₀ may be hydrogen or a C₁-C₃₀ alkyl group.

In some embodiments, an amount of the selective etching inhibitor may be in a range of 0.001 wt% to 20 wt% per 100 wt% of the etching composition.

In some embodiments, an amount of the first compound may be in a range of 0.001 wt% to 5 wt% per 100 wt% of the etching composition, and an amount of the second compound may be in a range of 0.001 wt% to 3 wt% per 100 wt% of the etching composition.

In some embodiments, the etching composition may have a pH in a range of 6.0 to 9.0.

According to an embodiment of the disclosure, a method of etching a metal-containing film may include preparing a substrate including a metal-containing film, and removing at least a portion of the metal-containing film by performing an etching process on the metal-containing film using the etching composition.

In some embodiments, the metal-containing film may include indium (In), titanium (Ti), aluminum (Al), tungsten (W), lanthanum (La), scandium (Sc), gallium (Ga), zinc (Zn), hafnium (Hf), cobalt (Co), copper (Cu), or any combination thereof.

In some embodiments, the metal-containing film may have a first region and a second region. The performing the etching process on the metal-containing film using the etching composition may include contacting at least a portion of the first region and at least a portion of the second region with the etching composition, etching part of the first region at a first etching rate of the etching composition, and etching part of the second region at a second rate of the etching composition. The second etching rate of the etching composition for etching the second region may be greater than the first etching rate of the etching composition for etching the first region.

In some embodiments, the first region may include Cu or Co, and the second region may include titanium nitride (TiN).

According to an embodiment of the disclosure, a method of manufacturing a semiconductor device may include preparing a substrate including a metal-containing film, removing at least a portion of the metal-containing film by performing an etching process on the metal-containing film using the etching composition, and preparing a semiconductor device by performing a subsequent manufacturing process on a structure having the substrate including the metal-containing film.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a process flow chart of an embodiment of a method of manufacturing a semiconductor device; and
FIGS. 2 and 3 are each a diagram briefly explaining an embodiment of a method of etching a metal-containing film.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figure, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC. As used herein, the singular forms "a," "an" and "the" are intended to include the plural forms as well, unless the context clearly indicates otherwise.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

### Target etching film

A target etching film may include a metal-containing film.

In this regard, an etching composition described below may be used in an etching process and/or a chemical mechanical polishing (CMP) process for the metal-containing film.

A metal included in the metal-containing film may be an alkali metal (e.g., sodium (Na), potassium (K), rubidium (Rb), cesium (Cs), etc.), an alkaline earth metal (e.g., beryllium (Be), magnesium (Mg), calcium (Ca), strontium (Sr), barium (Ba), etc.), a lanthanide metal (e.g., lanthanum (La), europium (Eu), terbium (Tb), ytterbium (Yb), etc.), a transition metal (e.g., scandium (Sc), yttrium (Y), titanium (Ti), zirconium (Zr), hafnium (Hf), vanadium (V), niobium (Nb), tantalum (Ta), chromium (Cr), molybdenum (Mo), tungsten (W), manganese (Mn), iron (Fe), ruthenium (Ru), osmium (Os), cobalt (Co), rhodium (Rh), nickel (Ni), copper (Cu), silver (Ag), zinc (Zn), etc.), a post-transition metal (e.g., aluminum (Al), gallium (Ga), indium (In), thallium (Tl), tin (Sn), bismuth (Bi), etc.), or any combination thereof.

In an embodiment, the metal-containing film may include In, Ti, Al, Cu, W, Co, La, Sc, Ga, Zn, Hf, or any combination thereof.

In one or more embodiments, the metal-containing film may include Al, Ti, La, W, Co, Cu, or any combination thereof.

In one or more embodiments, the metal-containing film may include Ti.

In one or more embodiments, the metal-containing film may include Ti and Al.

In one or more embodiments, the metal-containing film may include Cu.

In one or more embodiments, the metal-containing film may include Co.

The metal-containing film may include a metal, metal nitride, metal oxide, metal oxynitride, or a combination thereof.

The metal-containing film may include a metal, metal nitride, metal oxide, metal oxynitride, or any combination thereof, and each of the metal and a metal included each of the metal nitride, metal oxide, and metal oxynitride may include In, Ti, Al, La, Sc, Ga, Zn, Hf, or a combination thereof.

The metal-containing film may include metal nitride. A metal included in the metal nitride may include In, Ti, Al, La, Sc, Ga, Zn, Hf, or any combination thereof.

In one or more embodiments, the metal-containing film may include titanium nitride (TiN). The titanium nitride may further include In, Al, La, Sc, Ga, Hf, Zn, or any combination thereof. In one or more embodiments, the metal-containing film may include titanium nitride, titanium nitride that further includes Al (e.g., titanium/aluminum nitride (TiAlN)), titanium nitride that further includes La, or the like.

In one or more embodiments, the metal-containing film may include metal oxide. A metal included in the metal oxide may include Ti, Al, La, Sc, Ga, Hf, or any combination thereof. In an embodiment, the metal-containing film may include aluminum oxide (e.g., Al₂O₃), indium gallium zinc oxide (IGZO), or the like.

In one or more embodiments, the metal-containing film may include the metal and the metal nitride.

In one or more embodiments, the metal-containing film may further include, in addition to the aforementioned metal, a metalloid (e.g., boron (B), silicon (Si), germanium (Ge), arsenic (As), antimony (Sb), tellurium (Te), etc.), non-metal (e.g., nitrogen (N), phosphorus (P), oxygen (O), sulfur (S), selenium (Se), etc.), or any combination thereof.

For example, the metal-containing film may further include silicon oxide.

The metal-containing film may have a single-layer structure including (or consisting of) at least one type of material or a multi-layer structure or pattern structure including different materials from each other. For example, the metal-containing film may have i) a single-layer structure including (or consisting of) titanium nitride, ii) a double-layer structure or pattern structure including a first layer including (or consisting of) titanium nitride and a second layer including (or consisting of) titanium nitride, which further includes Al, iii) a double-layer structure or pattern structure including a first layer including (or consisting of) titanium nitride and a second layer including (or consisting of) aluminum oxide, iv) a double-layer structure or pattern structure including a first layer including (or consisting of) titanium nitride and a second layer including (or consisting of) Cu or Co, or the like.

In one or more embodiments, the metal-containing film may have a first region and a second region, and a second etching rate of an etching composition for etching the second region may be greater than a first etching rate of an etching composition for etching the first region. During the etching process and/or CMP process for the metal-containing film, at least a portion of the first region and at least a portion of the second region may be in contact with an etching composition, and since the second etching rate is greater than the first etching rate, the second region may be etched faster than the first region.

The first region and the second region may be present continuously or discontinuously. In addition, a layer (e.g., various insulating layers, etc.) may be arranged between the first region and the second region.

For example, the first region may include a metal, metal oxide (e.g., aluminum oxide), silicon oxide, or any combination thereof.

In an embodiment, the first region may include Cu or Co.

In an embodiment, the second region may include metal nitride.

In one or more embodiments, the second region may include i) titanium nitride, ii) titanium nitride further including In, Al, La, Sc, Ga, Zn, Hf, or any combination thereof, or iii) a combination thereof.

In one or more embodiments, each of the first region second region may include i) titanium nitride, ii) titanium nitride further including In, Al, La, Sc, Ga, Zn, Hf, or any combination thereof, or iii) a combination thereof.

In one or more embodiments, the first region may include Al, and the second region may not include Al.

In one or more embodiments, the first region may include titanium nitride further including Al (e.g., titanium/aluminum nitride (TiAIN)), and the second region may include titanium nitride.

In one or more embodiments, the first region may include a titanium nitride film further including Al (e.g., a titanium/aluminum nitride film (TiAlN film)), and the second region may include a titanium nitride film.

In one or more embodiments, the first region may be a titanium nitride film further including Al (e.g., a titanium/aluminum nitride film (TiAlN film)), and the second region may be a titanium nitride film.

In one or more embodiments, the first region may include Cu or Co, and the second region may not include Cu or Co.

In one or more embodiments, the first region may include Cu or Co, and the second region may include titanium nitride (TiN).

In one or more embodiments, the first region may include a Cu film or a Co film, and the second region may include a titanium nitride film (TiN film).

In one or more embodiments, the first region may be a Cu film or a Co film, and the second region may be a titanium nitride film (TiN film).

Etching a film described herein may refer to removing at least some of materials constituting a film to be etched.

### Etching composition

An etching composition may include an oxidizing agent, a buffer, and a selective etching inhibitor.

The etching composition may be used in an etching process and/or CMP process for the target etching film described herein, e.g., the metal-containing film.

The etching composition may further include water.

In an embodiment, the etching composition may consist of an oxidizing agent, a buffer, a selective etching inhibitor, and water.

In one or more embodiments, the etching composition may not include a water-soluble organic solvent, a nitrile-based solvent, a silanol compound, an alkylene glycol-based solvent, or the like.

### Oxidizing agent

The oxidizing agent may be a substance capable of oxidizing a metal, metal nitride, metal oxide, metal oxynitride, or any combination thereof (e.g., a substance capable of oxidizing a metal). For example, anions derived from the oxidizing agent may combine with metal-containing cations that are produced by oxidizing a metal, metal nitride, metal oxide, metal oxynitride, or any combination thereof included in metal-containing film, to form a water-soluble complex, which may serve to etch the metal-containing film.

In an embodiment, the oxidizing agent may not include a metal (e.g., metal ions, etc.).

In one or more embodiments, the oxidizing agent may include at least one of hydrogen peroxide, nitric acid, and ammonium sulfate.

In an embodiment, the oxidizing agent may include hydrogen peroxide.

For example, in a case where the metal-containing film includes titanium nitride and the oxidizing agent is hydrogen peroxide, upon contact of the etching composition with the metal-containing film, HO²⁻ and Ti-containing cations may combine to form a water-soluble complex, and accordingly, the metal-containing film may be etched.

In an embodiment, an amount (weight) of the oxidizing agent may be, for example, per 100 wt% of the etching composition, in a range of about 0.001 wt% to about 50 wt%, about 0.001 wt% to about 40 wt%, about 0.001 wt% to about 30 wt%, about 0.001 wt% to about 25 wt%, about 0.01 wt% to about 50 wt%, about 0.01 wt% to about 40 wt%, about 0.01 wt% to about 30 wt%, about 0.01 wt% to about 25 wt%, about 0.1 wt% to about 50 wt%, about 0.1 wt% to about 40 wt%, about 0.1 wt% to about 30 wt%, about 0.1 wt% to about 25 wt%, about 0.5 wt% to about 50 wt%, about 0.5 wt% to about 40 wt%, about 0.5 wt% to about 30 wt%, about 0.5 wt% to about 25 wt%, about 1.0 wt% to about 50 wt%, about 1.0 wt% to about 40 wt%, about 1.0 wt% to about 30 wt%, about 1.0 wt% to about 25 wt%, about 3.0 wt% to about 50 wt%, about 3.0 wt% to about 40 wt%, about 3.0 wt% to about 30 wt%, about 3.0 wt% to about 25 wt%, about 5.0 wt% to about 50 wt%, about 5.0 wt% to about 40 wt%, about 5.0 wt% to about 30 wt%, or about 5.0 wt% to about 25 wt%.

### Buffer

The buffer may serve to stabilize the etching composition during dilution and/or preparation of the etching composition, and to adjust pH of the etching composition. In addition, the buffer may serve to promote the production of anions derived from the oxidizing agent and stabilize a water-soluble complex formed by combining the anions with the metal-containing cations.

For example, when the metal-containing film includes titanium nitride and the oxidizing agent is hydrogen peroxide, the buffer may serve to maintain a high production concentration of HO²⁻ and stabilize a complex formed by combining HO²⁻ with Ti-containing cations.

In an embodiment, the buffer may include an ammonium salt.

In one or more embodiments, the ammonium salt may include a cation represented by Formula 5-1:

Formula 5-1 [N(R₅₁)(R₅₂)(R₅₃)(R₅₄)]⁺

wherein, in Formula 5-1, R₅₁ to R₅₄ may each independently be:
hydrogen; or
a C₁-C₃₀ alkyl group unsubstituted or substituted with deuterium, *-F, *-Cl, *-Br, *-I, *-OH, *-SH, a C₁-C₃₀ alkoxy group, a C₁-C₃₀ alkylthio group, or any combination thereof.
For example, R₅₁ to R₅₄ may each independently be:
hydrogen; or
a C₁-C₁₀ alkyl group unsubstituted or substituted with deuterium, *-OH, *-SH, a C₁-C₁₀ alkoxy group, C₁-C₁₀ alkylthio group, or any combination thereof.

In one or more embodiments, the ammonium salt may include an organic anion or an inorganic anion. For example, the organic anion may be a carboxylate-containing anion, and the inorganic anion may be a phosphate-containing anion or a halogen-containing anion.

In one or more embodiments, the ammonium salt may include a phosphate-containing anion, and the phosphate-containing anion may be dihydrogen phosphate ([H₂PO₄]⁻), hydrogen phosphate ([HPO₄]²), or phosphate ([PO₄]³⁻).

In one or more embodiments, the buffer may include diammonium hydrogen phosphate ((NH₄)₂(HPO₄)), ammonium dihydrogen phosphate ((NH₄)(H₂PO₄)), bis(tetramethylammonium) hydrogen phosphate ([N(CH₃)₄]₂(HPO₄)), (tetramethylammonium) dihydrogen phosphate ([N(CH₃)₄](H₂PO₄)), ammonium phosphonate ((NH4)₃PO₄), or any combination thereof.

An amount (weight) of the buffer may be, for example, per 100 wt% of the etching composition, in a range of about 0.01 wt% to about 20 wt%, about 0.01 wt% to about 15 wt%, about 0.01 wt% to about 10 wt%, about 0.01 wt% to about 5 wt%, about 0.01 wt% to about 3 wt%, about 0.1 wt% to about 20 wt%, about 0.1 wt% to about 15 wt%, about 0.1 wt% to about 10 wt%, about 0.1 wt% to about 5 wt%, about 0.1 wt% to about 3 wt%, about 0.5 wt% to about 20 wt%, about 0.5 wt% to about 15 wt%, about 0.5 wt% to about 10 wt%, about 0.5 wt% to about 5 wt%, or about 0.5 wt% to about 3 wt%.

### Selective etching inhibitor

The selective etching inhibitor may serve to selectively control an etching rate or the like by forming a protective film (e.g., a protective film against etching) on at least a portion of regions of the metal-containing film which is the target etching film and/or by interacting with at least one some of metal atoms.

The selective etching inhibitor may include a first compound represented by Formula 1 and a second compound. Formula 1 may be the same as described herein.

Here, the first compound and the second compound may be different from each other. Therefore, the selective etching inhibitor may include two or more different compounds. In this regard, the density and/or adsorption of the protective film that may be formed on at least a portion of regions of the metal-containing film that is the target etching film may be improved, thereby improving etching selectivity.

The first compound may be represented by Formula 1: 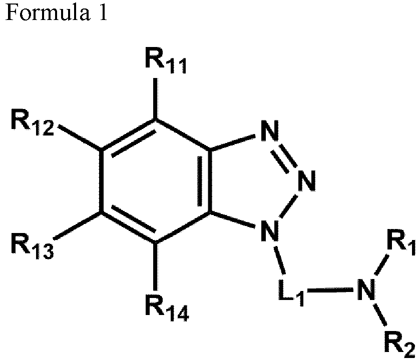 wherein, in Formula 1,
L₁ may be a C₁-C₃₀ alkylene group unsubstituted or substituted with deuterium, *-F, *-Cl, *-Br, *-I, *-OH, *-SH, or any combination thereof,
R₁ and R₂ may each independently be:
   hydrogen, deuterium, *-OH, or *-SH; or
   a C₁-C₃₀ alkyl group unsubstituted or substituted with deuterium, *-F, *-Cl, *-Br, *-I, *-OH, *-SH, a C₁-C₃₀ alkoxy group, a C₁-C₃₀ alkylthio group, or any combination thereof, R₁₁ to R₁₄ may each independently be:
   hydrogen, deuterium, a cyano group, *-F, *-Cl, *-Br, *-I, *-OH, *-SH, *-C(=O)-Q₁, *-NH-C(=O)-Q₁, *-C(=O)-O-Q₁, *-N(Q₁)(Q₂), or *-(O-CH₂CH₂)ₙ₁-OH; or
   a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, or a C₁-C₃₀ heterocyclic group, each unsubstituted or substituted with deuterium, cyano group, *-F, *-Cl, *-Br, *-I, *-OH, *-SH, *-C(=O)-Q₁₁, *-NH-C(=O)-Q₁₁, *-C(=O)-O-Q₁₁, *-N(Q₁₁)(Q₁₂), *-(O-CH₂CH₂)ₙ₁₁-OH, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof,
   n1 and n11 may each independently be an integer from 1 to 20,
   Q₁, Q₂, Q₁₁, and Q₁₂ may each independently be:
      hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
      a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof, and
      * indicates a binding site to a neighboring atom.

In an embodiment, L₁ in Formula 1 may be a C₁-C₁₀ alkylene group (or a C₁-C₆ alkylene group) unsubstituted or substituted with deuterium, *-F, *-Cl, *-Br, *-I, *-OH, *-SH, or any combination thereof.

In one or more embodiments, R₁ and R₂ in Formula 1 may each independently be:
hydrogen, deuterium, *-OH, or *-SH; or
a C₁-C₁₀ alkyl group unsubstituted or substituted with deuterium, *-F, *-Cl, *-Br, *-I, *-OH, *-SH, a C₁-C₁₀ alkoxy group, a C₁-C₁₀ alkylthio group, or any combination thereof.

In one or more embodiments, R₁ and R₂ in Formula 1 may be identical to each other.

In one or more embodiments, R₁ and R₂ in Formula 1 may be different from each other.

In one or more embodiments, at least one of R₁ and R₂ may not be hydrogen.

In one or more embodiments, R₁₁ to R₁₄ in Formula 1 may each independently be:
hydrogen, deuterium, a cyano group, *-F, *-Cl, *-Br, *-I, *-OH, *-SH, *-C(=O)-Q₁, or *-N(Q₁)(Q₂); or
a C₁-C₁₀ alkyl group unsubstituted or substituted with deuterium, cyano group, *-F, *-Cl, *-Br, *-I, *-OH, *-SH, *-C(=O)-Q₁₁, *-N(Q₁₁)(Q₁₂), a C₁-C₁₀ alkoxy group, a C₁-C₁₀ alkylthio group, or any combination thereof, and
Q₁, Q₂, Q₁₁, and Q₁₂ may each independently be:
   hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
   a C₁-C₁₀ alkyl group unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₁₀ alkoxy group, a C₁-C₁₀ alkylthio group, or any combination thereof.

For example, Q₁, Q₂, Q₁₁, and Q₁₂ may each independently be:
hydrogen, *-OH, *-SH, *-C(=O)-H, or *-C(=O)-OH; or
a C₁-C₁₀ alkyl group unsubstituted or substituted with *-OH, *-SH, *-C(=O)-H, *-C(=O)-OH, a C₁-C₁₀ alkoxy group, a C₁-C₁₀ alkylthio group, or any combination thereof.

In one or more embodiments, at least one of R₁ and R₂ (e.g., both R₁ and R₂) in Formula 1 may include *-OH, *-SH, a C₁-C₃₀ alkoxy group, or a C₁-C₃₀ alkylthio group.

In one or more embodiments, at least one of R₁ and R₂ (e.g., both R₁ and R₂) in Formula 1 may be a C₁-C₃₀ alkyl group unsubstituted or substituted with *-OH, *-SH, a C₁-C₃₀ alkoxy group, a C₁-C₃₀ alkylthio group, or any combination thereof. In this regard, the binding between oxygen and/or sulfur included *-OH, *-SH, a C₁-C₃₀ alkoxy group, and a C₁-C₃₀ alkylthio group and some metal atoms included in the metal-containing film may be improved, so that the density, width, adsorption, or the like of the protective film that may be formed on at least a portion of regions of the metal-containing film may be improved, thereby further improving the etching selectivity of the etching composition.

In an embodiment, at least one of R₁₁ to R₁₄ in Formula 1 may not be hydrogen.

In one or more embodiments, at least one of R₁₁ to R₁₄ in Formula 1 may be a hydrophobic substituent. For example, at least one of R₁₁ to R₁₄ may be a C₁-C₃₀ alkyl group or a C₁-C₁₀ alkyl group. In this regard, the protective film that may be formed on at least a portion of regions of the metal-containing film may be formed more effectively.

The second compound may include a ring, and the ring of the second compound may be:
a pyrazole group, an imidazole group, a triazole group, or a tetrazole group; or
a pyrazole group, an imidazole group, or a triazole group, each condensed with a benzene group, a pyridine group, a pyrimidine group, a pyrazine group, a pyridazine group, or any combination thereof.

In an embodiment, the ring of the second compound may be a pyrazole group, an imidazole group, a triazole group, a tetrazole group, an indazole group, a benzimidazole group, or a benzotriazole group.

In one or more embodiments, the second compound may include at least one of a compound represented by Formula 2-1 and a compound represented by Formula 2-2: 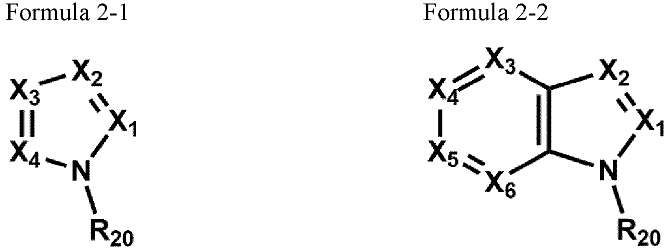 wherein, in Formulae 2-1 and 2-2,
X₁ may be N or C(R₂₁), X₂ may be N or C(R₂₂), X₃ may be N or C(R₂₃), X₄ may be N or C(R₂₄), X₅ may be N or C(R₂₅), and X₆ may be N or C(R₂₆), wherein at least one of X₁ to X₄ in Formula 2-1 may be N, and at least one of X₁ and X₂ in Formula 2-2 may be N,
R₂₀ to R₂₆ may each independently be:
   hydrogen, deuterium, a cyano group, *-F, *-Cl, *-Br, *-I, *-OH, *-SH, *-C(=O)-Q₁, *-NH-C(=O)-Q₁, *-C(=O)-O-Q₁, *-N(Q₁)(Q₂), or *-(O-CH₂CH₂)ₙ₁-OH; or
   a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, or a C₁-C₃₀ heterocyclic group, each unsubstituted or substituted with deuterium, cyano group, *-F, *-Cl, *-Br, *-I, *-OH, *-SH, *-C(=O)-Q₁₁, *-NH-C(=O)-Q₁₁, *-C(=O)-O-Q₁₁, *-N(Q₁₁)(Q₁₂), *-(O-CH₂CH₂)ₙ₁₁-OH, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof,
   n1 and n11 may each independently be an integer from 1 to 20,
   Q₁, Q₂, Q₁₁, and Q₁₂ may each independently be:
      hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
      a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof, and
      * indicates a binding site to a neighboring atom.

In an embodiment, 1, 2, or 3 of X₁ to X₄ in Formula 2-1 may be N.

In one or more embodiments, in Formula 2-2, X₃ may be C(R₂₃), X₄ may be C(R₂₄), X₅ may be C(R₂₅), and X₆ may be C(R₂₆).

In one or more embodiments, in Formula 2-1,
i) X₁ may be N, X₂ may be C(R₂₂), X₃ may be C(R₂₃), and X₄ may be C(R₂₄),
ii) X₁ may be C(R₂₁), X₂ may be N, X₃ may be C(R₂₃), and X₄ may be C(R₂₄),
iii) X₁ may be N, X₂ may be N, X₃ may be C(R₂₃), and X₄ may be C(R₂₄),
iv) X₁ may be N, X₂ may be C(R₂₂), X₃ may be N, and X₄ may be C(R₂₄),
v) X₁ may be N, X₂ may be C(R₂₂), X₃ may be C(R₂₃), and X₄ may be N,
vi) X₁ may be N, X₂ may be N, X₃ may be N, and X₄ may be C(R₂₄), or
vii) X₁ may be N, X₂ may be C(R₂₂), X₃ may be N, and X₄ may be N.

In one or more embodiments, in Formula 2-2,
1) X₁ may be N, X₂ may be C(R₂₂), X₃ may be C(R₂₃), X₄ may be C(R₂₄), X₅ may be C(R₂₅), and X₆ may be C(R₂₆),
2) X₁ may be C(R₂₁), X₂ may be N, X₃ may be C(R₂₃), X₄ may be C(R₂₄), X₅ may be C(R₂₅), and X₆ may be C(R₂₆), or
3) each of X₁ and X₂ may be N, X₃ may be C(R₂₃), X₄ may be C(R₂₄), X₅ may be C(R₂₅), and X₆ may be C(R₂₆).

In one or more embodiments, R₂₀ to R₂₆ may each independently be:
hydrogen, deuterium, a cyano group, *-F, *-Cl, *-Br, *-I, *-OH, *-SH, *-C(=O)-Q₁, or *-N(Q₁)(Q₂); or
a C₁-C₁₀ alkyl group unsubstituted or substituted with deuterium, cyano group, *-F, *-Cl, *-Br, *-I, *-OH, *-SH, *-C(=O)-Q₁₁, *-N(Q₁₁)(Q₁₂), a C₁-C₁₀ alkoxy group, a C₁-C₁₀ alkylthio group, or any combination thereof. Q₁, Q₂, Q₁₁, and Q₁₂ may each be the same as described in the present specification.

In one or more embodiments, in Formulae 2-1 and 2-2, R₂₀ to R₂₆ may each independently be:
hydrogen, deuterium, *-F, or *-N(Q₁)(Q₂); or
a C₁-C₃₀ alkyl group unsubstituted or substituted with deuterium, *-F, *-N(Q₁₁)(Q₁₂), or any combination thereof, and
Q₁, Q₂, Q₁₁, and Q₁₂ may each independently be hydrogen, deuterium, or a C₁-C₃₀ alkyl group.

In one or more embodiments, R₂₀ may be hydrogen or a C₁-C₃₀ alkyl group (e.g., a C₁-C₁₀ alkyl group).

In one or more embodiments, the first compound may be at least one of Compounds A1 to A5:

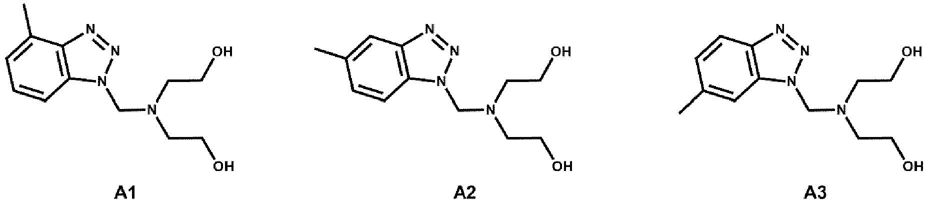

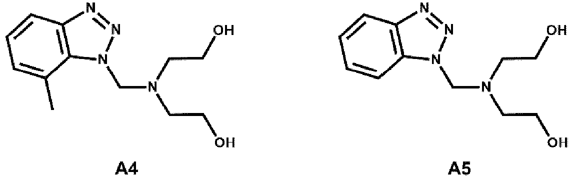

In one or more embodiments, the second compound may be at least one of Compounds B1 to B46:

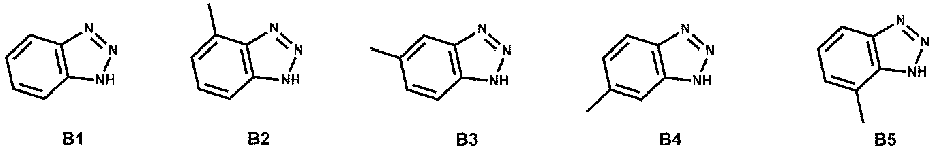

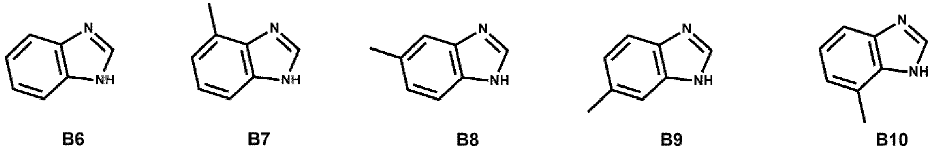

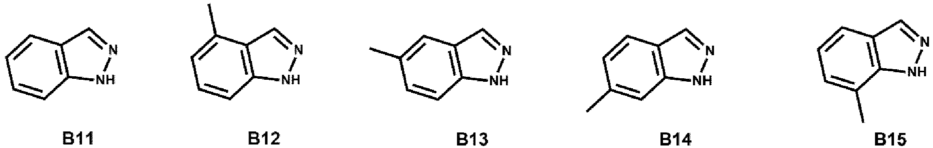

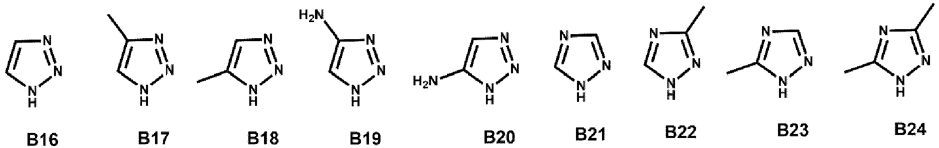

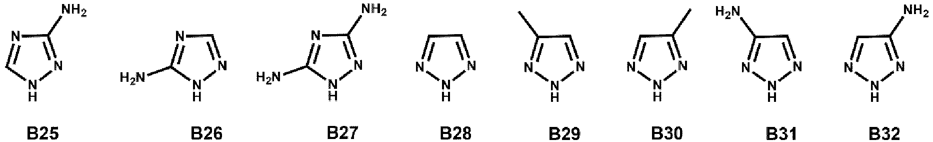

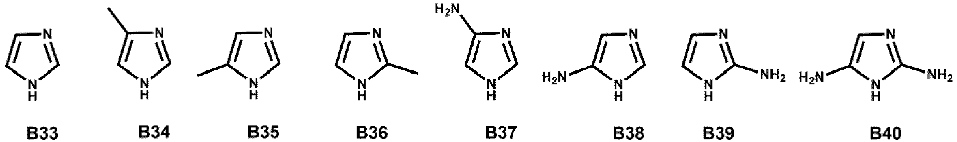

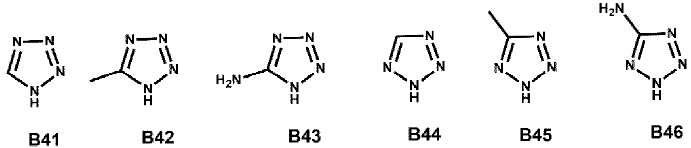

An amount (weight) of the selective etching inhibitor may be, per 100 wt% of the etching composition, in a range of about 0.001 wt% to about 20 wt%, about 0.001 wt% to about 15 wt%, about 0.001 wt% to about 10 wt%, about 0.001 wt% to about 5 wt%, about 0.001 wt% to about 1 wt%, about 0.001 wt% to about 0.5 wt%, about 0.01 wt% to about 20 wt%, about 0.01 wt% to about 15 wt%, about 0.01 wt% to about 10 wt%, about 0.01 wt% to about 5 wt%, about 0.01 wt% to about 1 wt%, about 0.01 wt% to about 0.5 wt%, about 0.05 wt% to about 20 wt%, about 0.05 wt% to about 15 wt%, about 0.05 wt% to about 10 wt%, about 0.05 wt% to about 5 wt%, about 0.05 wt% to about 1 wt%, about 0.05 wt% to about 0.5 wt%, about 0.1 wt% to about 20 wt%, about 0.1 wt% to about 15 wt%, about 0.1 wt% to about 10 wt%, about 0.1 wt% to about 5 wt%, about 0.1 wt% to about 1 wt%, or about 0.1 wt% to about 0.5 wt%.

An amount (weight) of the first compound may be, per 100 wt% of the etching composition, in a range of about 0.001 wt% to about 5 wt%, about 0.001 wt% to about 3 wt%, about 0.001 wt% to about 1 wt%, about 0.001 wt% to about 0.5 wt%, about 0.05 wt% to about 5 wt%, about 0.05 wt% to about 3 wt%, about 0.05 wt% to about 1 wt%, about 0.05 wt% to about 0.5 wt%, about 0.01 wt% to about 5 wt%, about 0.01 wt% to about 3 wt%, about 0.01 wt% to about 1 wt%, about 0.01 wt% to about 0.5 wt%, about 0.02 wt% to about 5 wt%, about 0.02 wt% to about 3 wt%, about 0.02 wt% to about 1 wt%, or about 0.02 wt% to about 0.5 wt%.

An amount (weight) of the second compound may be, per 100 wt% of the etching composition, about 0.001 wt% to about 3 wt%, about 0.001 wt% to about 1 wt%, about 0.001 wt% to about 0.5 wt%, about 0.05 wt% to about 3 wt%, about 0.05 wt% to about 1 wt%, about 0.05 wt% to about 0.5 wt%, about 0.01 wt% to about 3 wt%, about 0.01 wt% to about 1 wt%, about 0.01 wt% to about 0.5 wt%, about 0.02 wt% to about 5 wt%, about 0.02 wt% to about 3 wt%, about 0.02 wt% to about 1 wt%, or about 0.02 wt% to about 0.5 wt%.

When the amount of each of the selective etching inhibitor, the first compound, and the second compound is within the ranges above, the etching selectivity of the etching composition may be improved.

An amount (weight) of the first compound may be, per 100 wt% of the selective etching inhibitor, in a range of about 1 wt% to about 99 wt%, about 10 wt% to about 99wt%, about 30 wt% to about 99 wt%, about 50 wt% to about 99 wt%, about 70 wt% to about 99 wt%, about 75 wt% to about 99 wt%, about 1 wt% to about 90 wt%, about 10 wt% to about 90 wt%, about 30 wt% to about 90 wt%, about 50 wt% to about 90 wt%, about 70 wt% to about 90 wt%, about 75 wt% to about 90 wt%, about 1 wt% to about 85 wt%, about 10 wt% to about 85 wt%, about 30 wt% to about 85 wt%, about 50 wt% to about 85 wt%, about 70 wt% to about 85 wt%, or about 75 wt% to about 85 wt%.

In an embodiment, the amount (weight) of the first compound per 100 wt% of the etching composition may be greater than the amount (weight) of the second compound per 100 wt% of the etching composition.

The aforementioned etching composition may have a pH in a range of about 6.0 to about 9.0, about 6.0 to about 8.5, about 6.0 to about 8.0, about 6.5 to about 9.0, about 6.5 to about 8.5, about 6.5 to about 8.0, about 7.0 to about 9.0, about 7.0 to about 8.5, or about 7.0 to about 8.0. When the etching composition has a pH within the ranges above, the interaction between the selective etching inhibitor and metal atoms included in the metal-containing film may be more smoothly achieved.

In an embodiment, the etching composition may be used in an etching process and/or a CMP process for the metal-containing film. The metal-containing film may be the same as described herein.

In an embodiment, the etching composition may be used as a scavenger of an etching by-product, a scavenger of a post-etch process by-product, a scavenger of an ashing process by-product, a cleaning composition, a photoresist (PR) scavenger, an etching composition for packaging process, a cleaning agent for packaging process, a removing agent for adhesive substances of wafer, an etchant, a post-etch residue stripper, an ash residue cleaner, a PR residue stripper, a CMP cleaner, a post-CMP cleaner, or the like.

Etching method of metal-containing film and preparation method of semiconductor device

By using the aforementioned etching composition, the metal-containing film may be effectively etched.

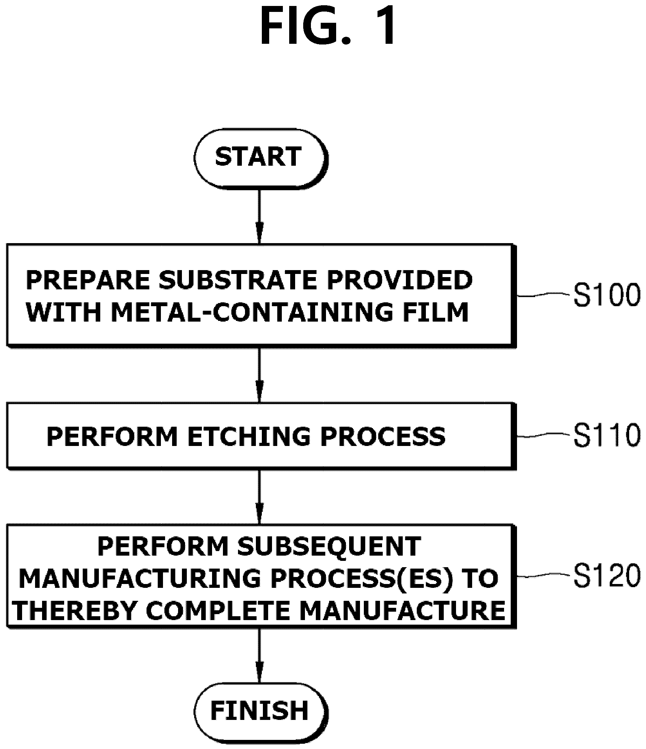

Referring to FIG. 1, an embodiment of an etching method of the metal-containing film may include: preparing a substrate provided with a metal-containing film S 100; and performing an etching process S 110 using the etching composition on the metal-containing film to remove at least a portion of the metal-containing film.

The metal-containing film may be the same as described herein.

In an embodiment, the metal-containing film may include In, Ti, Al, W, La, Sc, Ga, Zn, Hf, Co, Cu, or any combination thereof.

In one or more embodiments, the metal-containing film may include a metal, metal nitride, metal oxide, metal oxynitride, or a combination thereof.

By including the selective etching inhibitor, the etching composition may have excellent etching selectivity for the metal-containing film, and the productivity and efficiency of the etching process may be improved. Therefore, by using the etching process for the metal-containing film with the aforementioned etching composition, a semiconductor device having excellent performance may be prepared.

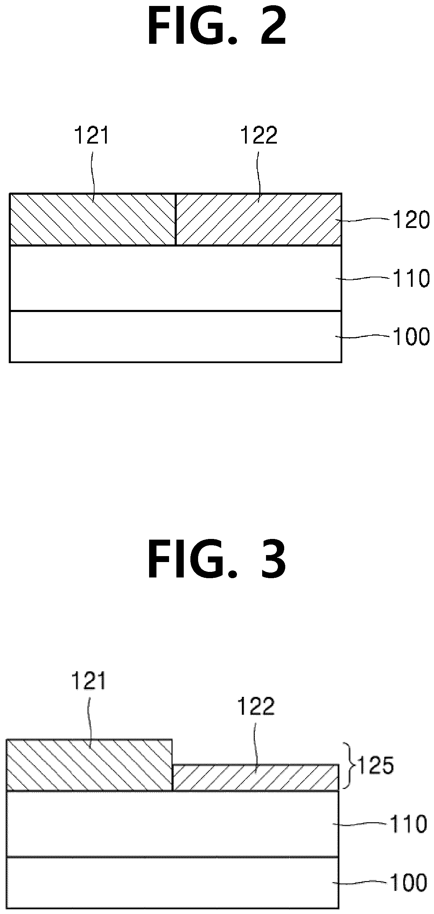

FIGS. 2 and 3 are each a diagram briefly explaining an embodiment of the method of etching the metal-containing film.

Referring to FIG. 2, a substrate 100 provided with a metal-containing film 120 may be provided. An interlayer 110 may be arranged between the substrate 100 and the metal-containing film 120. Although not shown in FIG. 2, circuitry elements (e.g., a transistor gate, metal lines, etc.), impurity regions, semiconductor layers, or the like may be disposed inside the substrate 100, on the substrate 100, and/or between the substrate 100 and the interlayer 110. In an embodiment, the metal-containing film 120 may be arranged directly on the substrate 100, and the interlayer 110 may be omitted.

The metal-containing film 120 may include a first region 121 and a second region 122. A second etching rate of the etching composition for etching the second region 122 may be greater than a first etching rate of the etching composition for etching the first region 121.

Referring to FIG. 3, when the etching composition is used for etching the metal-containing film 120, i) only at least a portion of the second region 122 may be etched, or ii) at least a portion of the second region 122 and at least a portion of the first region 121 may be etched, thereby forming a pattern of the metal-containing film 125. The etching process may be performed by contacting at least a portion of the first region 121 and at least a portion of the second region 122 with the etching composition.

The etching composition may be used to etch i) only at least a portion of the second region 122, or ii) each of at least a portion of the second region 122 and at least a portion of the first region 121. Referring to FIG. 3, the pattern of the metal-containing film 125 formed after etching includes at least a portion of the second region 122, but if necessary, the etching process may be performed to completely remove the second region 122 from the pattern of the metal-containing film 125. Likewise, various modifications may be possible.

In one or more embodiments, the first region 121 may include metal oxide (e.g., aluminum oxide), silicon oxide, W, Co, Cu, or any combination thereof.

In one or more embodiments, the second region 122 may include titanium nitride.

In one or more embodiments, the second region 122 may include i) titanium nitride, ii) titanium nitride further including In, Al, La, Sc, Ga, Zn, Hf, or any combination thereof, or iii) a combination thereof.

In one or more embodiments, each of the first region 121 and the second region 122 may include i) titanium nitride, ii) titanium nitride further including In, Al, La, Sc, Ga, Zn, Hf, or any combination thereof, or iii) a combination thereof.

In one or more embodiments, the first region 121 may include Cu or Co, and the second region 122 may not include Cu or Co.

In one or more embodiments, the first region 121 may include Cu or Co, and the second region 122 may include titanium nitride (TiN).

In one or more embodiments, the first region 121 may be a Cu film or Co film, and the second region 122 may be a titanium nitride film (TiN film).

In one or more embodiments, an etching rate ratio of the second region 122 to the first region 121 of the etching composition may be in a range of about 120 to about 500, about 150 to about 500, about 170 to about 500, about 176 to about 500, about 120 to about 400, about 150 to about 400, about 170 to about 400, about 176 to about 400, about 120 to about 300, about 150 to about 300, about 170 to about 300, about 176 to about 300, or about 176 to about 211. The etching rate ratio of the second region 122 to the first region 121 of the etching composition may be obtained by dividing a second etching rate of the etching composition for etching the second region 122 by a first etching rate of the etching composition for etching the first region 121. When the etching rate ratio of the second region 122 to the first region 121 of the etching composition is within the ranges above, the efficiency and productivity of the etching process may be improved.

In one or more embodiments, the first region 121 may include Cu, the second region 122 may include a titanium nitride film (TiN film), and an etching rate ratio of the second region 122 to the first region 121 of the etching composition (hereinafter referred to as "R(TiN / Cu)") may be in a range of about 120 to about 500, about 150 to about 500, about 170 to about 500, about 176 to about 500, about 120 to about 400, about 150 to about 400, about 170 to about 400, about 176 to about 400, about 120 to about 300, about 150 to about 300, about 170 to about 300, about 176 to about 300, or about 176 to about 211. The R(TiN / Cu) may be obtained by dividing an etching rate of the etching composition for etching the second region 122 including a titanium nitride film (TiN film) by an etching rate of the etching composition for etching the first region 121 including a Cu film.

In one or more embodiments, the first region 121 may include Cu or Co, and the etching composition may be used in a wet-etching process that requires suppressing etching of the first region 121.

In one or more embodiments, the etching composition may be used to etch the metal-containing film, and simultaneously to remove dry etched residues.

Referring to FIG. 1, a method of manufacturing a semiconductor device according to an embodiment may include: preparing a substrate provided with a metal-containing film S100; performing an etching process S110 using the etching composition on the metal-containing film to remove at least a portion of the metal-containing film; and manufacturing a semiconductor device by performing a subsequent process S120 on a structure having the substrate with the metal-containing film.

### Examples 1 and 2 and Comparative Examples 1 to 5

By mixing materials shown in Table 1 in the amounts shown in Table 1, etching compositions were prepared for each of Examples 1 and 2 and Comparative Examples 1 to 5. In Table 1, the oxidizing agent is hydrogen peroxide, the buffer is (NH4)₂HPO₄, and the remainder of each etching composition is water (deionized water).

### Evaluation Example 1

The etching composition of Example 1 was placed in two beakers and heated to 70 °C. Next, a titanium nitride film (TiN film) and a copper film (Cu film), which have been plasma-etched, were immersed in each beaker for 5 minutes, and the thicknesses of the TiN film and the Cu film were measured by using an ellipsometer (M-2000, J.A. Woolam), a 4 point probe, and XRF. Then, the etching rate (A/min) of the etching composition of Example 1 for etching the TiN film and the etching rate (A/min) of the etching composition of Example 1 for etching the Cu film were each evaluated. Subsequently, the R(TiN / Cu) of the etching composition of Example 1 was obtained by dividing the etching rate of the etching composition for etching the TiN film by the etching rate of the etching composition for etching the Cu film, and evaluated, and the results are summarized in Table 1.

The tests above were repeated by using the etching compositions of Example 2 and Comparative Examples 1 to 5, and the results are summarized along with the pH of each etching composition in Table 1.

**Table 1**

| | Oxidizing agent | Buffer | Selective etching inhibitor | | | | pH of etching composition | Etching rate of TiN (Å/min) | Etching rate of copper film (Å/min) | R (TiN / Cu) |
|---|---|---|---|---|---|---|---|---|---|---|
| | Amount (wt%) | Amount (wt%) | Compound 1 | Amount of Compound 1 (wt%) | Compound 2 | Amount of Compound 2 (wt%) | | | | |
| Example 1 | 25 | 0.5 | A1 | 0.2 | B1 | 0.05 | 7.5 | 253 | 1.2 | 211 |
| Example 2 | 25 | 0.5 | A1 | 0.2 | B3 | 0.05 | 7.5 | 247 | 1.4 | 176 |
| Comparative Example 1 | 25 | 0.5 | A1 | 0.25 | - | - | 7.4 | 251 | 2.2 | 114 |
| Comparative Example 2 | 25 | 0.5 | - | - | B1 | 0.25 | 7.6 | 244 | 2.4 | 102 |
| Comparative Example 3 | 25 | 0.5 | - | - | B3 | 0.25 | 7.6 | 227 | 3.3 | 69 |
| Comparative Example 4 | 25 | 0.5 | B1 | 0.125 | B3 | 0.125 | 7.5 | 240 | 3.1 | 77 |
| Comparative Example 5 | 25 | 0.5 | A1 | 0.2 | R1 | 0.05 | 7.4 | 243 | 2.6 | 93 |

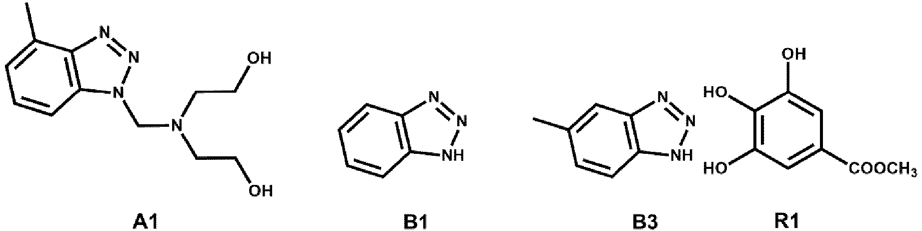

Referring to Table 1, the etching compositions of Examples 1 and 2 had excellent etching selectivity compared to the etching compositions of Comparative Examples 1 to 5, thereby improving the efficiency and productivity of the etching process.

According to the one or more embodiments, an etching composition may have excellent etching selectivity for a metal-containing film that is a target etching film and may be able to improve productivity and efficiency of an etching process, and thus use of the etching composition may lead to performance of an effective etching process and/or chemical mechanical polishing process on a target etching film. Accordingly, a semiconductor device prepared by using the etching process for the metal-containing film with the etching composition may have excellent performance.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An etching composition comprising:
an oxidizing agent;
a buffer; and
a selective etching inhibitor, wherein
the selective etching inhibitor comprises a first compound represented by Formula 1 and a second compound,
the first compound and the second compound are different from each other,
the second compound includes a ring, and
the ring of the second compound is one of
a pyrazole group, an imidazole group, a triazole group, or a tetrazole group; or
a pyrazole group, an imidazole group, or a triazole group, each condensed with a benzene group, a pyridine group, a pyrimidine group, a pyrazine group, a pyridazine group, or any combination thereof, 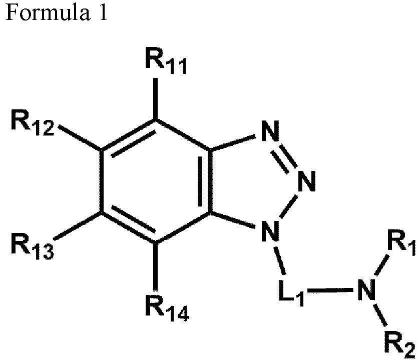
wherein, in Formula 1,
L₁ is a C₁-C₃₀ alkylene group unsubstituted or substituted with deuterium, *-F, *-Cl, *-Br, *-I, *-OH, *-SH, or any combination thereof,
R₁ and R₂ are each independently one of
hydrogen, deuterium, *-OH, or *-SH, or
a C₁-C₃₀ alkyl group unsubstituted or substituted with deuterium, *-F, *-Cl, *-Br, *-I, *-OH, *-SH, a C₁-C₃₀ alkoxy group, a C₁-C₃₀ alkylthio group, or any combination thereof,
R₁₁ to R₁₄ are each independently one of
hydrogen, deuterium, a cyano group, *-F, *-Cl, *-Br, *-I, *-OH, *-SH, *-C(=O)-Q₁, *-NH-C(=O)-Q₁, *-C(=O)-O-Q₁, *-N(Q₁)(Q₂), or *-(O-CH₂CH₂)ₙ₁-OH, or
a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, or a C₁-C₃₀ heterocyclic group, each unsubstituted or substituted with deuterium, cyano group, *-F, *-Cl, *-Br, *-I, *-OH, *-SH, *-C(=O)-Q₁₁, *-NH-C(=O)-Q₁₁, *-C(=O)-O-Q₁₁, *-N(Q₁₁)(Q₁₂), *-(O-CH₂CH₂)ₙ₁₁-OH, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof,
n1 and n11 are each independently an integer from 1 to 20,
Q₁, Q₂, Q₁₁, and Q₁₂ are each independently one of
hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂, or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof, and
* indicates a binding site to a neighboring atom.

2. The etching composition of claim 1, wherein the oxidizing agent is hydrogen peroxide; and/or
wherein an amount of the oxidizing agent is in a range of 0.1 wt% to 50 wt% per 100 wt% of the etching composition.

3. The etching composition of claims 1 or 2, wherein the buffer comprises an ammonium salt.

4. The etching composition of claim 3, wherein the ammonium salt comprises a cation represented by Formula 5-1:
Formula 5-1 [N(R₅₁)(R₅₂)(R₅₃)(R₅₄)]⁺
wherein, in Formula 5-1,
R₅₁ to R₅₄ are each independently one of
hydrogen, or
a C₁-C₃₀ alkyl group unsubstituted or substituted with deuterium, *-F, *-Cl, *-Br, *-I, *-OH, *-SH, a C₁-C₃₀ alkoxy group, a C₁-C₃₀ alkylthio group, or any combination thereof; or
wherein the ammonium salt comprises a phosphate-containing anion, and
the phosphate-containing anion is dihydrogen phosphate ([H₂PO₄]⁻), hydrogen phosphate ([HPO₄]²⁻), or phosphate ([PO₄]³⁻).

5. The etching composition of any of claims 1-4, wherein an amount of the buffer is in a range of 0.01 wt% to 20 wt% per 100 wt% of the etching composition.

6. The etching composition of any of claims 1-5, wherein at least one of R₁ and R₂ is a C₁-C₃₀ alkyl group unsubstituted or substituted with *-OH, *-SH, a C₁-C₃₀ alkoxy group, a C₁-C₃₀ alkylthio group, or any combination thereof; and/or
wherein at least one of R₁₁ to R₁₄ is not hydrogen.

7. The etching composition of any of claims 1-6, wherein the ring of the second compound is a pyrazole group, an imidazole group, a triazole group, a tetrazole group, an indazole group, a benzimidazole group, or a benzotriazole group.

8. The etching composition of any of claims 1-7, wherein the second compound comprises at least one of a compound represented by Formula 2-1 and a compound represented by Formula 2-2: 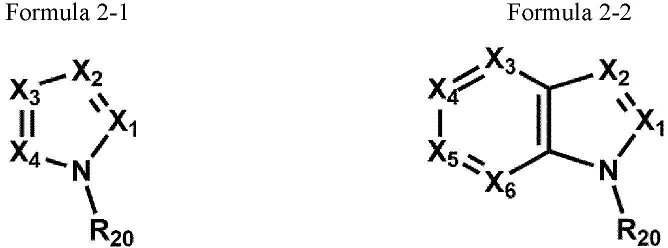
wherein, in Formulae 2-1 and 2-2,
X₁ is N or C(R₂₁), X₂ is N or C(R₂₂), X₃ is N or C(R₂₃), X₄ is N or C(R₂₄), X₅ is N or C(R₂₅), and X₆ is N or C(R₂₆), wherein at least one of X₁ to X₄ in Formula 2-1 is N and at least one of X₁ and X₂ in Formula 2-2 is N,
R₂₀ to R₂₆ are each independently one of
hydrogen, deuterium, a cyano group, *-F, *-Cl, *-Br, *-I, *-OH, *-SH, *-C(=O)-Q₁, *-NH-C(=O)-Q₁, *-C(=O)-O-Q₁, *-N(Q₁)(Q₂), or *-(O-CH₂CH₂)ₙ₁-OH, or
a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, or a C₁-C₃₀ heterocyclic group, each unsubstituted or substituted with deuterium, cyano group, *-F, *-Cl, *-Br, *-I, *-OH, *-SH, *-C(=O)-Q₁₁, *-NH-C(=O)-Q₁₁, *-C(=O)-O-Q₁₁, *-N(Q₁₁)(Q₁₂), *-(O-CH₂CH₂)ₙ₁₁-OH, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof,
n1 and n11 are each independently an integer from 1 to 20,
Q₁, Q₂, Q₁₁, and Q₁₂ are each independently one of
hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂, or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₁-C₃₀ alkylthio group, a C₂-C₃₀ alkenyl group, a C₃-C₃₀ carbocyclic group, a C₁-C₃₀ heterocyclic group, or any combination thereof, and
* indicates a binding site to a neighboring atom;,
preferably wherein R₂₀ is hydrogen or a C₁-C₃₀ alkyl group.

9. The etching composition of any of claims 1-8, wherein an amount of the selective etching inhibitor is in a range of 0.001 wt% to 20 wt% per 100 wt% of the etching composition.

10. The etching composition of any of claims 1-9, wherein
an amount of the first compound is in a range of 0.001 wt% to 5 wt% per 100 wt% of the etching composition, and
an amount of the second compound is in a range of 0.001 wt% to 3 wt% per 100 wt% of the etching composition.

11. The etching composition of any of claims 1-10, wherein the etching composition has a pH in a range of 6.0 to 9.0.

12. A method of etching a metal-containing film, the method comprising:
preparing a substrate including a metal-containing film; and
removing at least a portion of the metal-containing film by performing an etching process on the metal-containing film using the etching composition of any of claims 1-11.

13. The method of claim 12, wherein the metal-containing film comprises indium (In), titanium (Ti), aluminum (Al), tungsten (W), lanthanum (La), scandium (Sc), gallium (Ga), zinc (Zn), hafnium (Hf), cobalt (Co), copper (Cu), or any combination thereof.

14. The method of claims 12 or 13, wherein
the metal-containing film has a first region and a second region,
the performing the etching process on the metal-containing film using the etching composition includes contacting at least a portion of the first region and at least a portion of the second region with the etching composition, etching part of the first region at a first etching rate of the etching composition, and etching part of the second region at a second rate of the etching composition, and
the second etching rate of the etching composition for etching the second region is greater than the first etching rate of the etching composition for etching the first region; preferably wherein
the first region comprises copper or cobalt, and
the second region comprises titanium nitride (TiN).

15. The method of any of claims 12-14, further comprising performing a subsequent manufacturing process on a structure having the substrate including the metal-containing film to manufacture a semiconductor device.
